# FASCICULE DE BREVET EUROPEEN

(11) **EP 3 207 324 B1**
(45) Date de publication et mention de la délivrance du brevet: **01.04.2020**
(21) Numéro de dépôt: 15777702.0
(22) Date de dépôt: 12.10.2015
(51) Int. Cl.: F28D 15/02, F28D 15/04, F28D 15/06, F28F 1/00, H05K 7/20

(54) **CALODUC PLAT AVEC FONCTION RESERVOIR**
FLACHES WÄRMEROHR MIT RESERVOIRFUNKTION
FLAT HEAT PIPE WITH RESERVOIR FUNCTION

(30) Priorité: 15.10.2014 FR 1459885
(43) Date de publication de la demande: 23.08.2017
(73) Titulaire: Euro Heat Pipes, 1400 Nivelles (BE)
(72) Inventeur: MOHAUPT, Mikael, 7181 Feluy (BE); VAN OOST, Stéphane, 1331 Rosieres (BE)
(74) Mandataire: Plasseraud IP
(86) Numéro de dépôt international: PCT/EP2015/073505
(87) Numéro de publication internationale: WO 2016/058966

(56) Documents cités:
- DE-U1-202005 008 792
- US-A- 6 082 443
- US-A1- 2009 159 243

## Description

La présente invention est relative aux caloducs, et plus généralement aux systèmes de transfert thermique à fluide de travail diphasique. Plus précisément, on s'intéresse aux caloducs plats chargés d'évacuer les calories produites par un équipement électronique, comme un processeur, un transistor de puissance, ou tout autre composant électronique dégageant des calories, ou toute autre source de chaleur.

Dans un tel caloduc, le fluide de travail est vaporisé dans une zone appelée 'évaporateur' et le fluide de travail est condensé dans une zone appelée 'condenseur'. Le caloduc en question est formé par une enveloppe hermétique dans laquelle est enfermée une certaine quantité de fluide de travail qui circule en boucle fermée entre les zones évaporateur et condenseur grâce au phénomène de capillarité engendré par une structure capillaire interposée entre la zone évaporateur et la zone condenseur.

En particulier, on s'intéresse ici aux caloducs plats présentant deux faces opposées, à savoir une première face dite 'chaude' recevant des calories du composant à refroidir et une seconde face dite 'froide' destinée à évacuer les calories vers un radiateur à ailettes ou un échangeur thermique à liquide conventionnel. Ce type de caloduc est aussi appelé « Heat Spreader » dans le jargon du métier. On connaît ce genre caloduc « Heat Spreader » par exemple des documents US3613778, US5642776, US7392836 ou US20100326632. Le document US 6 082 443 A décrit un caloduc plat suivant le préambule de la revendication 1.

Par ailleurs, on assiste à un accroissement des densités de flux surfacique à évacuer au niveau du composant électronique, et par conséquent il est un besoin d'accroître l'efficacité et l'optimisation des caloducs 'Heat Spreader'.

Les configurations de l'art connu n'apportent pas de solution optimale pour gérer la variation de volume de liquide en fonction de la température de fonctionnement.

En effet, le volume occupé par la phase liquide augmente avec la température de fonctionnement, et l'excédent de liquide peut diminuer les performances du caloduc en particulier au niveau des échanges thermiques du côté condenseur, qui peut se trouver masqué, en partie ou totalement, par cet excédent de liquide.

Il est donc apparu un besoin d'améliorer la gestion de l'excédent de liquide pour maintenir les performances du caloduc à un niveau optimal sur une gamme étendue de températures de fonctionnement.

Dans ce but, l'invention a pour objet un caloduc plat suivant l'intitulé de la revendication 1.

En d'autres termes, le canal collecteur joue le rôle de vase d'expansion en captant l'excédent de liquide de manière à maintenir un fonctionnement optimal des canaux de condensation.

Dans divers modes de réalisation de l'invention, on peut éventuellement avoir recours en outre à l'une et/ou à l'autre des dispositions suivantes :
- les canaux de vaporisation et/ou les canaux de condensation peuvent être formés comme des rainures, soit aménagées dans la structure capillaire, soit aménagées sur la face intérieure respectivement des première et seconde plaque(s) ; ceci représente une configuration géométrique simple qui peut être obtenue par des moyens de fabrication standard, usinage, estampage formage, etc... ;
- le canal collecteur est avantageusement mis en communication fluide avec chaque canal de condensation au moyen d'un passage étroit/restreint. On obtient ainsi un effet d'aspiration par la formation d'un ménisque et grâce au phénomène de capillarité ;
- le passage étroit est préférentiellement agencé à l'extrémité connectée au réservoir de chaque rainure de condensation ; ceci s'avère une disposition avantageuse à l'opposé de l'extrémité d'arrivée de vapeur un peu plus chaude ;
- le diamètre hydraulique du passage étroit est de préférence strictement inférieur au diamètre hydraulique du canal de condensation ; on favorise ainsi la formation d'un ménisque de liquide à l'endroit du passage étroit ;
- on choisit de préférence la dimension du passage étroit de façon à ce qu'un ménisque de liquide s'y forme et y demeure, selon le fluide de travail choisi et quelle que soit l'orientation par rapport au champ de gravité, de sorte que la pression capillaire que ce ménisque génère compense la pression hydrostatique générée par le champ de gravité dans n'importe quelle direction;
- on choisit avantageusement la masse de fluide de travail pour que le réservoir soit entièrement rempli de la phase vapeur à la température minimale de fonctionnement du caloduc ; on optimise ainsi la quantité de fluide nécessaire pour le fonctionnement sur une plage de températures prescrites ;
- l'enveloppe formée par la première plaque, la deuxième plaque et la bordure est réalisée de préférence en matériau céramique ; matériau dont le coefficient de dilatation thermique est compatible avec les coefficients de dilatation thermique des composants électroniques ; ce qui évite les risques de stress mécanique ;
- la structure capillaire est réalisée de préférence en matériau céramique ; ainsi la dilatation thermique de la structure capillaire est cohérente avec celle de l'enveloppe ; ce qui diminue encore les risques de stress mécanique.

D'autres aspects, buts et avantages de l'invention apparaîtront à la lecture de la description suivante d'un mode de réalisation de l'invention, donné à titre d'exemple non limitatif. L'invention sera également mieux comprise en regard des dessins joints sur lesquels :
- la figure 1 est une vue générale en perspective d'un caloduc selon l'invention dans son environnement d'utilisation,
- la figure 2 est une vue en coupe transversale d'un caloduc selon l'invention, selon un plan de coupe II-II visibles à la figure 3,
- la figure 3 est une vue en coupe horizontale du caloduc de la figure 2, selon un plan de coupe III-III visibles à la figure 2,
- la figure 4 représente une vue en perspective éclatée montrant la plaque côté condensation et la structure capillaire du caloduc de la figure 2,
- la figure 5 représente une vue éclatée de côté et en coupe du caloduc de la figure 2, selon un plan de coupe V-V visibles à la figure 3,
- la figure 6 représente plus en détail le passage rétréci formé entre le canal collecteur formant réservoir et un canal de condensation,
- la figure 7 est une vue analogue à la figure 5, et représente une variante de réalisation en configuration assemblée.

Sur les différentes figures, les mêmes références désignent des éléments identiques ou similaires.

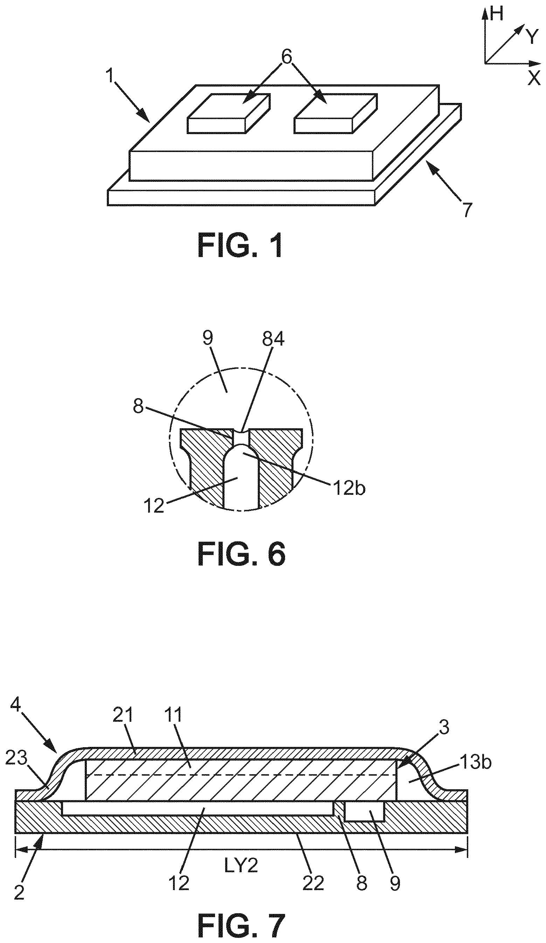

La figure 1 montre un système comprenant un caloduc plat **1** qui permet d'évacuer des calories produites par des composants dissipatifs **6** ('source chaude') en direction d'un élément **7** pouvant recevoir ces calories appelé ici 'source froide' **7.** Dans l'exemple illustré, on définit un plan de référence **XY**. L'interface physique entre les composants dissipatifs **6** et le caloduc **1** est parallèle à ce plan de référence ainsi que l'interface physique entre le caloduc plat **1** et une plaque appartenant à la source froide **7.** Le flux de calories est dispersé dans toutes les directions X, Y et H par le fluide de travail qui s'écoule à l'intérieur du caloduc, pour être dissipé à la connexion entre la plaque condenseur 22 et la source froide 7, c'est-à-dire selon la direction transversale **H** perpendiculaire au plan de référence, mais aussi selon les directions X et Y du plan de référence. On appelle aussi ce type de caloduc plat un « Heat Spreader » car la surface d'évacuation de calories du côté de la source froide 7 est plus importante que la surface d'admission des calories en provenance de la (des) source(s) chaude(s) 6.

À l'intérieur du caloduc plat **1** se trouve un fluide de travail diphasique **5** (c'est-à-dire comprenant une portion en phase liquide **5L** et une portion en phase vapeur **5V),** destiné à prélever des calories de la source chaude **6** et à les évacuer en direction de la source froide **7.**

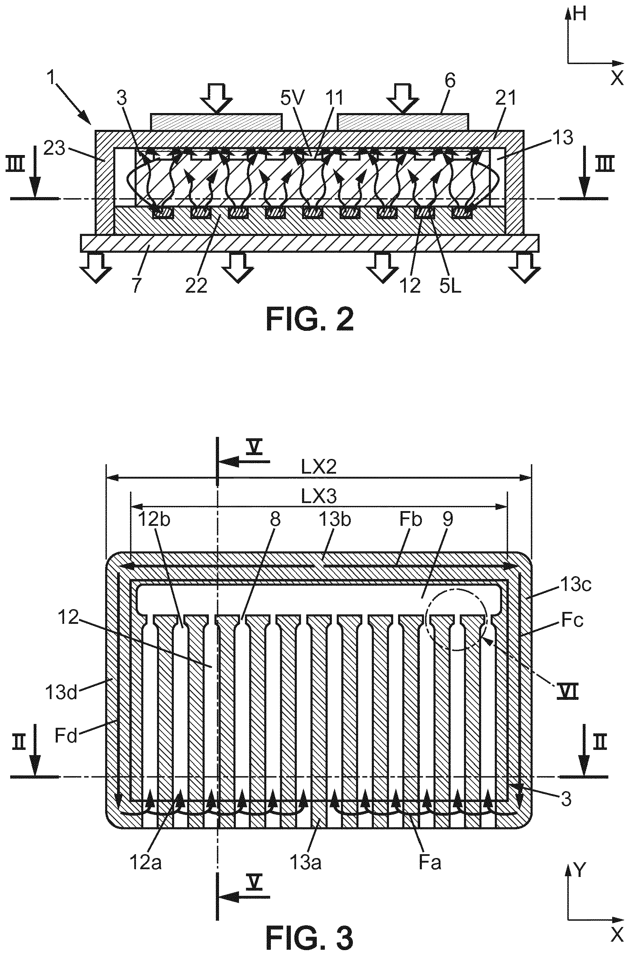

En référence aux figures 2 à 5, le caloduc **1** comprend une première plaque **21,** destinée à recevoir des calories depuis la source chaude, une seconde plaque **22** destinée à évacuer des calories vers la source froide **7.** La seconde plaque **22** est agencée en vis-à-vis de la première plaque **21** et parallèlement par rapport à la première plaque **21,** à distance selon la direction **H.**

On note ici que la direction **H** ne coïncide pas forcément avec la verticale du champ de gravité éventuel, de même le plan de référence **XY** ne coïncide pas forcément avec un plan horizontal.

Avantageusement, l'épaisseur du caloduc **1** selon la direction H (entre les faces externes des première et deuxième plaques 21,22) est par exemple inférieure à 20 mm, voire inférieure à 15mm, voire même inférieure à 10mm ; ainsi, le caloduc peut être facilement intégré dans une carte informatique ou dans une unité de contrôle électronique. Toutefois, il faut noter que le principe de la présente invention peut être appliqué avec n'importe quelles dimensions.

En outre, une bordure **23** relie de manière étanche les première et seconde plaques **21,22** ; ainsi, les parois pleines des première et seconde plaques, avec ladite bordure, forment un espace intérieur clos (enceinte hermétique et étanche) renfermant le fluide de travail diphasique **5.** Une fois l'enceinte scellée, il n'y a plus d'échange de matière entre l'espace intérieur clos et l'extérieur ; par conséquent, la quantité de fluide de travail reste constante même si les conditions de température et de pression varient dans le temps.

Entre les première et seconde plaques **21,22** est interposée une structure capillaire **3,** qui a pour fonction d'aspirer le fluide en phase liquide et de créer un saut de pression capable de contre-balancer toutes les pertes de charges du circuit. Ainsi le fluide est mis en mouvement par cette pompe capillaire dans le caloduc. Cette structure capillaire **3** peut être formée par une masse poreuse (par exemple à base de métal fritté) ou bien par une structure en treillis ou de type paille de fer. La structure capillaire **3** peut aussi être obtenue à partir d'un matériau céramique poreux, ou à partir d'un matériau plastique poreux. La taille des pores est choisie en fonction du fluide de travail en phase liquide et notamment de sa tension de surface (rayon du ménisque qui se forme spontanément). La taille des pores peut typiquement être comprise entre 1 micromètres (pm) et 100 micromètres, voire comprise entre 1 µm et 20 µm et préférentiellement comprise entre 2 µm et 5 µm. Pour faciliter la lecture des figures, la structure capillaire 3 a été représentée avec des hachures espacées, et sans hachures sur la figure 3.

La structure capillaire **3** se remplit de liquide. Le flux de chaleur appliqué par les composants dissipatifs 6 fait vaporiser le liquide en surface du matériau capillaire qui localement s'assèche ce qui attire ainsi le fluide de travail en phase liquide et le met en mouvement dans le caloduc. Cependant, si la température de fonctionnement du caloduc se met à augmenter suite aux conditions externes propres au système de refroidissement, il se trouve que le volume occupé par la phase liquide excède le volume qui peut être hébergé à l'intérieur de la structure capillaire. Dès lors, il y a un excédent de phase liquide **5L** qui se trouve en dehors de la structure capillaire **3.**

En effet, la masse volumique ρL de la phase liquide diminue lorsque sa température augmente alors qu'à l'inverse, la masse volumique ρV de la phase vapeur augmente. Par conséquent, comme la masse globale de fluide dans le caloduc reste inchangée, le volume liquide relatif occupé par la phase liquide **5L** à l'intérieur de l'enceinte close du caloduc augmente lorsque la température augmente ce qui conduit à un excédent de liquide.

Un excédent de liquide qui se trouverait dans les canaux de condensation **12** conduirait à dégrader les échanges thermiques du phénomène de condensation et un gradient de température plus important qui s'avérerait néfaste.

On note que le caloduc **1** peut être utilisé dans une application terrestre où le champ de gravité règne, mais aussi dans un environnement spatial ou les forces de gravité sont beaucoup plus faibles voire négligeables.

En raison de l'apport de calories à l'endroit de la première plaque **21** (c'est-à-dire côté évaporateur), le fluide de travail en phase liquide **5L** qui se trouve à cet endroit se vaporise en absorbant ces calories. De manière avantageuse, on prévoit des canaux de vaporisation **11** adjacents à la première plaque pour faciliter l'évacuation de la vapeur ainsi créée et permettre l'admission en permanence d'autre fluide en phase liquide. Les canaux de vaporisation **11** peuvent être formés comme illustré comme des rainures dans la structure capillaire, mais elles peuvent aussi être aménagées sur la face interne de la première plaque **21.**

La vapeur **5V** créée du côté évaporateur circule par des passages de transfert **13** en direction d'une zone de condensation qui se trouve à l'endroit de la deuxième plaque 22. À cet endroit, en raison de la température plus basse de la source froide, la vapeur se re-condense sous forme liquide. Dans l'exemple illustré, ceci se produit dans des canaux de condensation **12** adjacents à la seconde plaque **22.** Dans l'exemple illustré, les canaux de condensation **12** sont agencés sur la face interne de la deuxième plaque. Dans une réalisation alternative, ils pourraient être formés comme des rainures à l'intérieur de la structure capillaire **3.**

Les changements de phase liquide-vapeur et vapeur-liquide se produisent à une température donnée, déterminée par l'équilibre Psat,Tsat (conditions de saturation), et par conséquent, un tel caloduc à fluide à changement de phase liquide-vapeur, permet d'avoir d'une part un écart de température très faible, voire négligeable, entre la première plaque et la deuxième plaque et d'autre part une homogénéité quasi-parfaite de la température du fluide à l'intérieur du caloduc et donc sur l'ensemble de la surface **27** formant l'interface avec la source froide 7.

On note que idéalement la vapeur ne traverse pas la structure capillaire remplie de liquide ; ainsi, la structure capillaire remplie de liquide forme une barrière pour la vapeur que l'on appelle 'étanchéité capillaire'.

Afin de loger l'excédent de liquide qui peut se former lorsque la température de fonctionnement augmente, il est prévu avantageusement selon la présente invention de disposer un canal collecteur **9** formant réservoir, en communication fluide avec chaque canal de condensation 12.

Ce réservoir **9** a pour fonction de capter un excédent éventuel de liquide, de manière systématique cet excédent éventuel de liquide s'accumule naturellement au condenseur ; le réservoir selon l'invention attire et capte l'excédent de liquide comme il sera détaillé plus loin et ainsi cet excédent de liquide ne s'accumule pas dans les canaux de condensation **12**.

Dans l'exemple illustré, les canaux de condensation **12** s'étendent selon la direction **Y** parallèlement les uns aux autres ; le canal collecteur réservoir **9** s'étend perpendiculairement aux canaux de condensation c'est-à-dire selon la direction **X.** Dans la configuration illustrée, le caloduc présente une forme générale parallélépipédique, toutefois il n'est pas exclu d'avoir d'autres dispositions géométriques, comme par exemple une configuration de disque ou galette où les canaux sont disposés en étoile ou tout autre forme permettant de faire le lien entre source chaude et source froide.

Chaque canal de condensation **12** s'étend entre une première extrémité **12a** ouverte vers le passage de transfert **13** et une seconde extrémité **12b** à l'endroit de laquelle une communication fluide **8** est établie avec le canal collecteur formant réservoir **9.**

Le raccordement **8** entre le canal collecteur **9** et chaque canal de condensation est avantageusement réalisé au moyen d'un passage étroit (passage restreint) **8** ; plus précisément le diamètre hydraulique du passage étroit **8** est strictement inférieur au diamètre hydraulique du canal de condensation **12.**

À cet endroit se forme un ménisque de liquide **84** (Fig. 6) qui occupe le volume du passage étroit **8.**

Ce ménisque de liquide **84** génère une pression capillaire qui compense la pression hydrostatique générée par le champ de gravité dans la rainure réservoir **9** suivant un angle quelconque que peut faire la direction **X** par rapport à la verticale.

Selon le fluide de travail choisi, la largeur du passage étroit **8** peut être choisie comme inférieure aux trois-quarts de la largeur de la rainure de condensation, voire inférieure à la moitié de la largeur de la rainure de condensation, ou même inférieure au tiers.

Le réservoir **9** est bordé sur sa face supérieure par la structure capillaire **3.** Donc la phase liquide peut entrer ou sortir du réservoir uniquement par les passages étroits **8** susmentionnés et/ou par aspiration par la structure capillaire.

Par ailleurs, le canal collecteur **9** n'étant pas soumis à l'arrivée de vapeur, sa température va être légèrement inférieure à la température régnant dans les canaux de condensation. Du fait d'un léger différentiel de pression qui s'ensuit entre le canal de condensation et l'intérieur du réservoir **9,** le fluide à l'état liquide est aspiré vers l'intérieur du réservoir.

Selon une disposition avantageuse, on peut prévoir que le diamètre hydraulique et le différentiel de pression qui se produit sont suffisants pour compenser les effets du champ de gravité quelle que soit l'orientation selon laquelle le caloduc est positionné. D'ailleurs, l'orientation peut être variable selon le temps si le caloduc est embarqué dans un moyen de transport (train, avion,...) ou dans un appareil nomade (laptop, tablette,...).

Dans l'exemple illustré, le passage de transfert **13** servant à véhiculer la vapeur est formé par un espace libre qui fait tout le tour de la structure capillaire c'est-à-dire sur quatre côtés, à savoir deux cavités latérales **13c,13d,** une cavité postérieure **13b** situé proche du réservoir est une cavité antérieure **13a** située à l'opposé du canal collecteur, cette cavité antérieure **13a** s'ouvrant directement sur les premières extrémités **12a** de chaque canal de condensation.

Une première extrémité **11a** de chaque canal de vaporisation **11** débouche dans la cavité antérieure **13a** et une seconde extrémité **11b** de chaque canal de vaporisation débouche dans la cavité postérieure **13b.** Les flux de vapeur à travers des passages de transfert sont repérés par les signes **Fa, Fb, Fc** et **Fd** sur la figure 3.

On détermine la quantité de fluide de travail qui doit être contenue dans l'enceinte close du caloduc 1 grâce à la connaissance de la température minimale de fonctionnement du caloduc, dite **T_min_op.**

Ainsi, on choisit idéalement la masse de fluide **5** pour que la phase liquide **5L** occupe tout le volume de la structure capillaire mais pas plus ; autrement dit on choisit la masse de fluide **5** pour que le réservoir **9** soit entièrement rempli de la phase vapeur **5V** à la température minimale de fonctionnement **T_min_op** du caloduc.

Lorsque la température de fonctionnement du caloduc augmente à partir de **T_min_op,** il se produit un excédent de liquide et le réservoir **9** se remplit alors.

S'il advient que température de fonctionnement du caloduc est inférieure à **T_min_op,** la structure capillaire n'est alors pas complètement gavée de liquide, le réservoir est alors complètement rempli de vapeur. Dans ce cas, la performance de transfert thermique du caloduc peut être sous optimale mais le caloduc pourra fonctionner en mode dégradé (oscillations de débit de fluide et/ou de température de fonctionnement, voire ré-augmentation de cette dernière jusqu'à repasser au-dessus de **T_min_op).**

Le volume du réservoir **9** peut être déterminé pour admettre une quantité de liquide 5L en excès qui correspond à une température maximale de fonctionnement **T_max_op.**

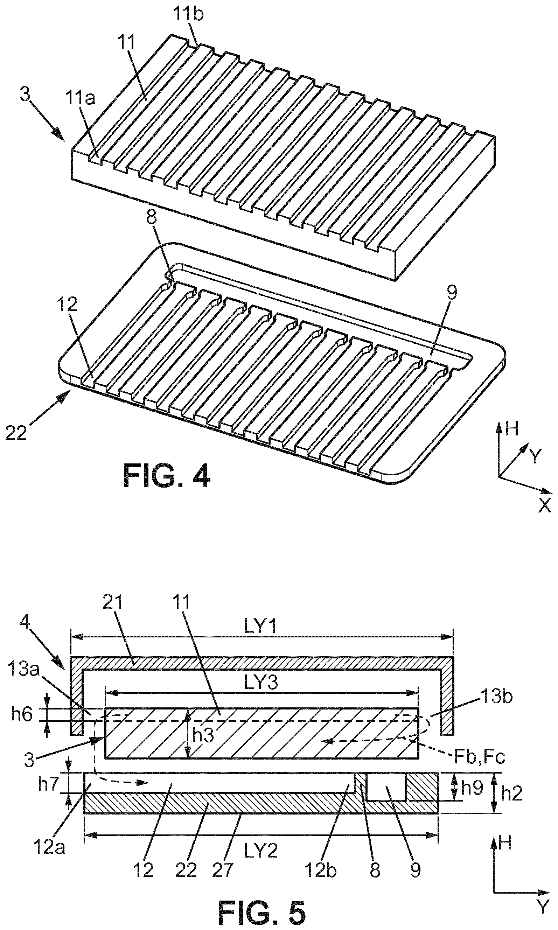

Les première et seconde plaques **21,22** et la bordure **23** peuvent être formées en matériau métallique (Ni, Cu, acier inoxydable,...) ou en matériau céramique (Al2O3, AlSiC, AIN, ...), ou encore en matériau plastique. On note que la bordure **23** peut former une pièce distincte ou peut être obtenue en un seul tenant avec une des plaques, par exemple la première plaque comme illustré à la figure 5, la pièce référencée **4** incluant la première plaque et la bordure. On scelle la bordure 23 par brasage, soudure laser, collage structurel ou autre.

Dans une réalisation, la seconde plaque, les rainures de condensation et le canal collecteur forment ensemble une pièce embase référencée **2.**

La bordure pourrait aussi se présenter comme un accostage dans le plan de référence XY, avec les bords de chacune des plaques qui viennent se jointer, la première plaque présentant un bord embouti décalé comme ceci est illustré à la figure 7.

Le fluide de travail **5** utilisé est de préférence un fluide dit « basse pression » qui limite les contraintes mécaniques sur l'enveloppe du caloduc, on peut utiliser par exemple de l'eau, du méthanol, de l'acétone, de l'éthanol ou un fluide réfrigérant quelconque.

Dans l'exemple illustré, la structure capillaire **3** présente une forme générale parallélépipédique avec une largeur **LX3,** une longueur **LY3** est une hauteur **h3.** La première plaque **21** présente une longueur **LY1** correspondant sensiblement à la somme de **LY3** plus la largeur des passages antérieurs et postérieurs **12a,12b** plus l'épaisseur de bordure. La seconde plaque **22** présente une largeur **LX2,** une longueur **LY2** est une hauteur **h2.**

La hauteur **h7** des rainures de condensation peut être identique à la hauteur **h9** du canal collecteur formant réservoir ; mais cette dernière peut être supérieure h9>h7 ; on peut aussi choisir h9<h7, selon les besoins et les contraintes de l'application visée.

La hauteur de rainures de vaporisation est notée **h6** et peut être voisine de la hauteur **h7.**

Il faut remarquer que la section des rainures (coté vaporisation et/ou coté condensation) peut être carrée comme illustrée, mais aussi rectangle, triangulaire, semi-circulaire etc.

Concernant les possibilités d'assemblage du caloduc lui-même ou du caloduc dans son environnement mécanique, on peut prévoir des trous (débouchants ou non ; filetés ou non) dans les premières et secondes plaques et dans la structure capillaire.

On remarque que le réservoir pourrait stocker du liquide gelé en cas de conditions de température particulière ; le réservoir peut aussi stocker des gaz non condensables.

La connexion avec la source froide est soit directement établie par assemblage ; soit peut se faire par l'addition d'ailettes dans le cas d'échanges convectifs avec un fluide externe comme source froide.

On remarque que sans sortir du cadre de la présente invention les première et seconde plaques 21,22 pourraient ne pas être parallèles entre elles.

Avantageusement, le système est complètement passif, il ne contient aucun composant actif, il ne nécessite aucune maintenance, et fonctionne de préférence selon n'importe quelle orientation dans l'espace.

Pour le remplissage initial du caloduc, on prévoit un orifice de remplissage et un tuyau (non représentés aux figures), l'orifice de remplissage étant, après l'introduction de la quantité de fluide de travail prescrite, fermé par une vanne ou par un bouchon ou définitivement scellé.

On note que la forme de la cavité formant réservoir peut être quelconque ; outre la configuration d'un canal collecteur comme représentée aux figures, on pourrait aussi avoir une cavité cylindrique avec les rainures qui partent en étoile et s'y raccordent.

De même, on note que la cavité formant réservoir pourrait être formée en plusieurs parties, soit isolées les unes des autres, soit communiquant entre elles par des passages étranglés ce qui limite la hauteur hydrostatique apparente totale.

## Revendications

1. Caloduc plat (1) à fluide de travail diphasique liquide-vapeur, comprenant :
- une première plaque (21), destinée à recevoir des calories depuis une source chaude (6),
- une seconde plaque (22), destinée à évacuer des calories vers une source froide (7), agencée en vis-à-vis et sensiblement parallèlement par rapport à la première plaque,
- une bordure (23) reliant de manière étanche les première et seconde plaques, pour former un espace intérieur clos renfermant le fluide de travail diphasique (5),
- une structure capillaire (3), interposée entre les première et seconde plaques (21,22),
- des canaux de vaporisation (11) adjacents à la première plaque,
- au moins un passage de transfert (13) mettant en communication les canaux d'évaporation avec les canaux de condensation pour le transport de vapeur (5V),
**caractérisé en ce que** le caloduc comprend
- des canaux de condensation (12) adjacents à la seconde plaque,
- au moins un canal collecteur (9) formant réservoir, en communication fluide avec chaque canal de condensation, ledit canal collecteur étant adjacent à la deuxième plaque (22), de sorte que le canal collecteur est agencé pour attirer et stocker un excédent de phase liquide (5L).

2. Caloduc selon la revendication 1, dans lequel les canaux de vaporisation et/ou les canaux de condensation sont formés par des rainures, soit aménagées dans la structure capillaire (3), soit aménagées sur la face intérieure respectivement des première et seconde plaque(s).

3. Caloduc selon l'une des revendications 1 à 2, dans lequel le canal collecteur est mis en communication fluide avec chaque canal de condensation (12) au moyen d'un passage étroit (8).

4. Caloduc selon la revendication 3, dans lequel le passage étroit est agencé à l'extrémité connectée (12b) au réservoir de chaque rainure de condensation (12).

5. Caloduc selon l'une des revendications 3 à 4, dans lequel le diamètre hydraulique du passage étroit (8) est strictement inférieur au diamètre hydraulique du canal de condensation.

6. Caloduc selon l'une des revendications 3 à 5, dans lequel on choisit la dimension du passage étroit (8) de façon à ce qu'un ménisque de liquide (84) s'y forme et y demeure, selon le fluide de travail choisi et quelle que soit l'orientation par rapport au champ de gravité, de sorte que la pression capillaire que ce ménisque génère compense la pression hydrostatique générée par le champ de gravité dans n'importe quelle direction.

7. Caloduc selon l'une des revendications 1 à 6, dans lequel on choisit la masse de fluide (5) pour que le réservoir (9) soit entièrement rempli de la phase vapeur (5V) à la température minimale de fonctionnement du caloduc.

8. Caloduc selon l'une des revendications 1 à 7, dans lequel l'enveloppe formée par la première plaque (21), la deuxième plaque (22) et la bordure (23) est réalisée en matériau céramique.

9. Caloduc selon l'une des revendications 1 à 8, dans lequel la structure capillaire (3) est réalisée en matériau céramique.

## Patentansprüche

1. Flaches Wärmerohr (1) mit zweiphasigem Flüssig/Dampf-Arbeitsfluid, aufweisend:
- eine erste Platte (21), um Wärme aus einer Wärmequelle (6) aufzunehmen,
- eine zweite Platte (22), um Wärme hin zu einer Kältequelle (7) auszuleiten, die der ersten Platte zugewandt und zu dieser im Wesentlichen parallel angeordnet ist,
- eine Umrandung (23), die die erste und die zweite Platte dichtend verbindet, um einen geschlossenen Innenraum zu bilden, der das zweiphasige Arbeitsfluid (5) einschließt,
- eine Kapillarstruktur (3), die zwischen der ersten und der zweiten Platte (21, 22) angeordnet ist,
- wobei die Verdampfungskanäle (11) an die erste Platte angrenzen,
- zumindest einen Durchlaufkanal (13), der die Verdampfungskanäle mit den Verflüssigungskanälen zum Transport von Dampf (5V) miteinander in Verbindung setzt,
**dadurch gekennzeichnet, dass** das Wärmerohr aufweist:
- Verflüssigungskanäle (12) angrenzend an die zweite Platte;
- mindestens einen Sammelkanal (9), der ein Reservoir bildet, das in fluidischer Verbindung mit jedem Verflüssigungskanal ist, wobei der Sammelkanal derart an die zweite Platte (22) angrenzt, dass der Sammelkanal eingerichtet ist, einen Überschuss der Flüssigphase (5L) anzuziehen und zu speichern.

2. Wärmerohr nach Anspruch 1, wobei die Verdampfungskanäle und/oder die Verflüssigungskanäle durch Nuten gebildet sind, entweder in der Kapillarstruktur (3) ausgebildet sind oder auf der Innenfläche der ersten bzw. zweiten Platte ausgebildet sind.

3. Wärmerohr nach einem der Ansprüche 1 bis 2, wobei der Sammelkanal mittels eines schmalen Durchgangs (8) in fluidische Verbindung mit jedem Verflüssigerkanal (12) gesetzt wird.

4. Wärmerohr nach Anspruch 3, wobei der schmale Durchgang an dem Ende (12b) angeordnet ist, das mit dem Reservoir von jeder Verflüssigungsnut (12) verbunden ist.

5. Wärmerohr nach einem der Ansprüche 3 bis 4, wobei der Hydraulikdurchmesser des schmalen Durchgangs (8) grundsätzlich kleiner ist als der Hydraulikdurchmesser des Verflüssigungskanals.

6. Wärmerohr nach einem der Ansprüche 3 bis 5, wobei die Abmessungen des schmalen Durchgangs (8) derart gewählt sind, dass sich dort ein Flüssigkeitsmeniskus (84) bildet und dort gemäß dem gewählten Arbeitsfluid und ungeachtet der Ausrichtung bezüglich des Schwerkraftfelds verbleibt, so dass der Kapillardruck, den dieser Meniskus erzeugt, den hydrostatischen Druck, der von dem Schwerkraftfeld erzeugt wird, in jedweder Richtung ausgleicht.

7. Wärmerohr nach einem der Ansprüche 1 bis 6, wobei die Fluidmasse (5) ausgewählt wird, damit das Reservoir (9) bei der Minimalbetriebstemperatur des Wärmerohrs vollständig mit der Dampfphase (5V) gefüllt ist.

8. Wärmerohr nach einem der Ansprüche 1 bis 7, wobei die von der ersten Platte (21), der zweiten Platte (22) und der Umrandung (23) gebildete Umhüllung aus einem Keramikmaterial ausgebildet ist.

9. Wärmerohr nach einem der Ansprüche 1 bis 8, wobei die Kapillarstruktur (3) aus einem Keramikmaterial ausgebildet ist.

## Claims

1. Flat heat pipe (1) with a two-phase liquid-vapor working fluid, comprising:
- a first plate (21), intended to receive thermal energy from a heat source (6),
- a second plate (22), intended to transfer thermal energy to a cold source (7), arranged opposite and substantially parallel to the first plate,
- an edge sealingly connecting the first and second plates, to form a closed internal space enclosing the two-phase working fluid (5),
- a capillary structure (3), interposed between the first and second plates,
- vaporization channels (11) adjacent to the first plate,
- at least one transfer passage (13) placing the evaporation channels in communication with the condensation channels for the transport of vapor (5V),
**characterized in that** the heat pipe comprises
- condensation channels (12) adjacent to the second plate,
- at least one collection channel (9) forming a reservoir, in fluid communication with each condensation channel, said collection channel being adjacent to the second plate; such that the collection channel is arranged to attract and store the excess liquid phase (5L).

2. Heat pipe according to claim 1, wherein the vaporization channels and/or the condensation channels are formed by grooves arranged in the capillary structure (3) or arranged on the inside face of the first and second plates respectively.

3. Heat pipe according to one of claims 1 to 2, wherein the collection channel is placed in fluid communication with each condensation channel (12) by means of a narrow passage (8) .

4. Heat pipe according to claim 3, wherein the narrow passage is arranged at the end (12b) connected to the reservoir, of each condensation groove (12).

5. Heat pipe according to one of claims 3 to 4, wherein the hydraulic diameter of the narrow passage (8) is strictly less than the hydraulic diameter of the condensation channel.

6. Heat pipe according to one of claims 3 to 5, wherein the size of the narrow passage (8) is chosen so that a liquid meniscus (84) is formed therein and remains therein, based on the working fluid chosen and regardless of the orientation with respect to the field of gravity, such that the capillary pressure generated by this meniscus compensates for the hydrostatic pressure generated by the field of gravity in any direction.

7. Heat pipe according to one of claims 1 to 6, wherein the mass of fluid (5) is selected so that the reservoir (9) is completely filled with vapor phase (5V) at the minimum operating temperature of the heat pipe.

8. Heat pipe according to one of claims 1 to 7, wherein the envelope formed by the first plate (21), the second plate (22), and the edge (23) is made of ceramic material.

9. Heat pipe according to one of claims 1 to 8, wherein the capillary structure is made of ceramic material.
